Europäisches Patentamt

European Patent Office

Office européen des brevets

(19)

(11) Veröffentlichungsnummer: **0 088 780**
**B1**

(12) **EUROPÄISCHE PATENTSCHRIFT**

(45) Veröffentlichungstag der Patentschrift:
01.04.87

(51) Int. Cl.⁴: **G 21 F 1/12,** H 05 K 9/00

(21) Anmeldenummer: 82902813.3

(22) Anmeldetag: **23.09.82**

(86) Internationale Anmeldenummer:
**PCT/EP 82/00214**

(87) Internationale Veröffentlichungsnummer:
**WO 83/01149 (31.03.83** Gazette 83/8)

(54) SCHUTZDECKE.

(30) Priorität: **23.09.81 DE 3137853**

(43) Veröffentlichungstag der Anmeldung:
**21.09.83 Patentblatt 83/38**

(45) Bekanntmachung des Hinweises auf die Patenterteilung:
**01.04.87 Patentblatt 87/14**

(84) Benannte Vertragsstaaten:
**AT CH FR GB LI**

(56) Entgegenhaltungen:
**DE - U - 7 206 455**
**FR - A - 804 362**
**US - A - 2 928 948**
**US - A - 2 983 821**
**US - A - 3 390 491**

(73) Patentinhaber: **MICHAEL GEISELER**
**DBF-VERTRIEBS-GMBH, Arabellastrasse 5,**
**D-8000 Munchen 81 (DE)**

(72) Erfinder: **OBERBACH, Josef, Schlossstrasse 9,**
**D-8022 Grünwald (DE)**

(74) Vertreter: **Wagner, Karl H., WAGNER & GEYER**
**Patentanwälte Gewuerzmuehlstrasse 5 Postfach 246,**
**D-8000 München 22 (DE)**

## Beschreibung

Die Erfindung betrifft eine Schutzdecke mit einem flexiblen, flächenförmigen Aufbau, insbesondere in Grösse eines Bettes, bestehend aus einer Einlage aus einer metallisierten Kunststoff-Folie, die in eine obere und untere Umhüllung eingeschlagen ist, wobei die metallisierte Schicht mit Erde verbindbar ist und die Umhüllungen durchlöcherte Kunststoff-Folien sind.

Eine derartige Schutzdecke zeigt das DE-U-7 206 455.

Die US-A-3 390 491 betrifft eine Blaslufthalle, deren doppelwandige, aufblasbare Aussenwand aus zwei beabstandeten, luftundurchlässigen Hüllen besteht und eine Abschirmung gegen elektromagnetische Wellen gewährleistet. Die äussere und innere Hülle sind dabei geerdet.

Der Erfindung liegt die Aufgabe zugrunde, eine Schutzdecke der eingangs geschilderten Art zu verbessern.

Zur Lösung dieser Aufgabe dienen die im Hauptanspruch gekennzeichneten Merkmale. Die abhängigen Ansprüche enthalten zweckmässige weitere Ausbildungen.

Die Anordnung von Luftschichten zwischen den einzelnen Lagen der Decke, insbesondere zwischen den beiden metallisierten Folien, ergibt eine höchst wirksame Dampfsperre und damit eine besonders gute Wirkung hinsichtlich Wärme- und Kälteschutz.

In den Zeichnungen sind Ausführungsbeispiele der erfindungsgemässen Schutzdecke dargestellt. Es zeigen:

Fig. 1 eine schematische Ansicht der Schutzdecke;

Fig. 2 einen Teilschnitt längst Linie II–II in Fig. 1;

Fig. 3 einen Schnitt durch ein anderes Ausführungsbeispiel der erfindungsgemässen Schutzdecke;

Fig. 4 einen Teilschnitt durch ein drittes Ausführungsbeispiel der erfindungsgemässen Schutzdecke;

Fig. 5 die erfindungsgemäss bevorzugte Anschlussart der Erdungslitze an der Schutzdecke;

Fig. 6 eine bevorzugte Ausbildung des Erdungssteckers;

Fig. 7 eine andere Ansicht des Erdungssteckers gemäss Fig. 6.

Fig. 8 ein weiteres besonders bevorzugtes Ausführungsbeispiel einer erfindungsgemässen Schutzdecke, wobei wie bei der Darstellung gemäss Fig. 3 die Kunststoffschutzfolien jeweils weggelassen sind.

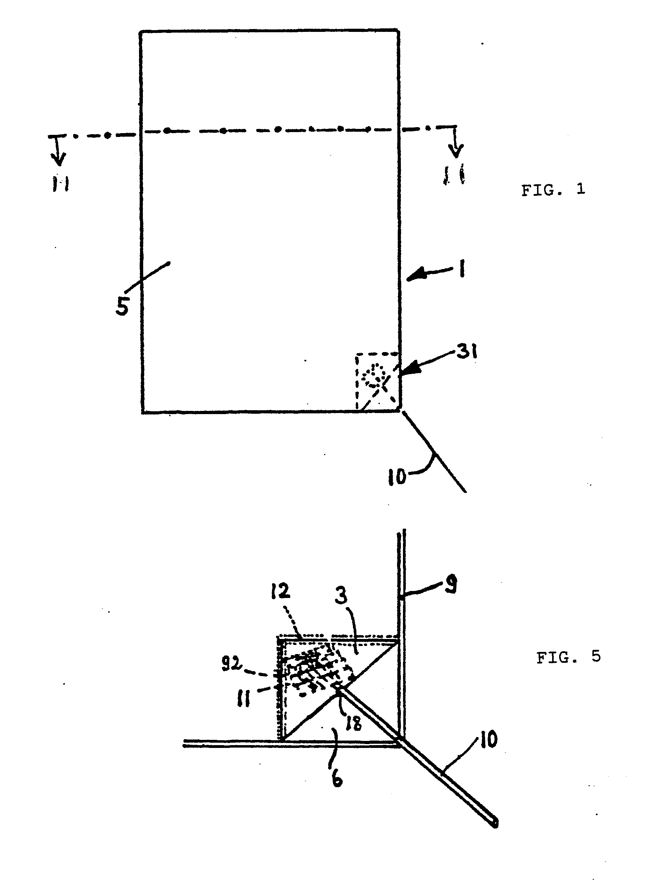

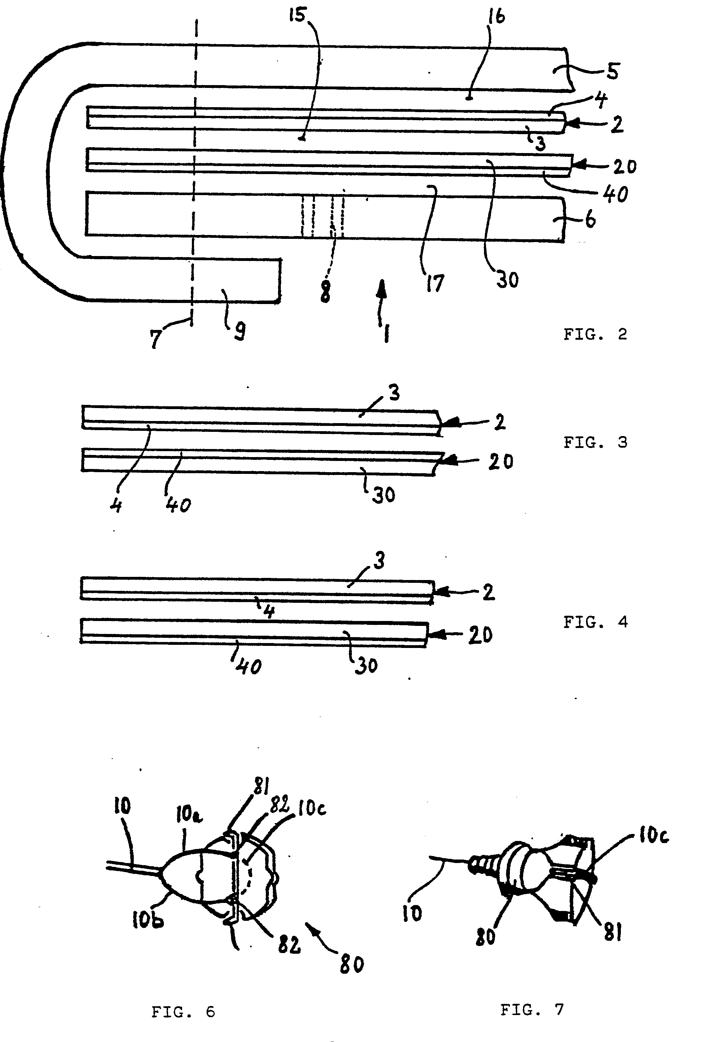

Die gemäss der Erfindung aufgebaute Schutzdecke 1 weist eine äussere Umhüllung bestehend aus zwei Kunststoffschutzfolien 5 und 6 auf, wobei die in Fig. 1 und 2 oben liegende Kunststoffschutzfolie 5 ein Umschlagteil 9 besitzt, um mit der Kunststoffschutzfolie 6 in der in Fig. 2 gezeigten Weise sich zu überlappen. Zwei Spezialfolien 2, 20 haben in etwa die gleiche Grösse wie die Kunststoffschutzfolie 6 und sind in der Nähe ihrer Ränder mit der Kunststoffschutzfolie 5 sowie in deren Umschlagteil 9 in der in Fig. 2 bei 7 gezeigten Weise vernäht. Je nach dem gewünschten Schutzbereich können die Schutzdecken 1 in verschiedenen Grössen, beispielsweise in der Grösse eines Betts, hergestellt sein.

Die Spezialfolien 2, 20 werden beispielsweise von der Firma Dupont hergestellt und bestehen jeweils aus einer dünnen Kunststoffträgerfolie 3, 30 mit einer darauf aufgedampften dünnen Metallschicht 4, 40. Die beiden Spezialfolien 2, 20 sind lediglich aufeinander gelegt, so dass sich zwischen den beiden Spezialfolien 2, 20 eine Luftschicht 15 bildet. Weitere Luftschichten 16, 17 liegen zwischen den Spezialfolien 2, 20 und den benachbarten Kunststoffschutzfolien 5 beziehungsweise 6. Die Kunststoffschutzfolien 5, 6 können von der Art sein, wie sie bei der Automobilherstellung zur Auskleidung des Automobildaches, des sogenannten «Himmels» verwendet werden. Demgemäss ist eine Vielzahl von Löchern 8 (von denen nur einige dargestellt sind) in den Kunststoffschutzfolien 5, 6 vorgesehen.

Gemäss der Erfindung können die beiden Spezialfolien 2, 20 in der in Fig. 2 gezeigten Weise angeordnet sein, das heisst die Kunststoffträgerfolien 3, 30 weisen aufeinander zu. Es ist aber auch möglich, die beiden Spezialfolien 2, 20 in der in Fig. 3 oder 4 gezeigten Weise anzuordnen, das heisst gemäss Fig. 3 weisen die beiden Metallschichten 4, 40 zueinander hin, während gemäss Fig. 4 die Anordnung wechselseitig erfolgt ist, d.h. die Metall- oder Metallisierungsschicht 4 der Spezialfolie 2 weist zur Kunststoffträgerfolie 30 der Spezialfolie 20 hin.

In Fig. 5 ist im einzelnen der erfindungsgemässe Anschluss der Erdungslitze 10 an die Spezialfolien 2, 20 dargestellt. Das von seiner Isolierung freigelegte Ende der Erdungslitze 10 wird in zwei Litzenanteile 11 aufgeteilt, wobei in Fig. 5 nur der eine Litzenanteil 11 dargestellt ist, während der andere Litzenanteil 11 in Fig. 5 nicht zu sehen ist. Die in Fig. 5 gezeigte Anschlussart gilt für das in Fig. 2 gezeigte Ausführungsbeispiel, kann aber sinngemäss auch bei den Fig. 3 und 4 Verwendung finden. Bevor im Bereich einer Ecke 31 der Schutzdecke 1 die Kunststoffschutzfolie 5 mit ihrem Umschlagteil 9 sowie der Kunststoffschutzfolie 6 und den umhüllten Spezialfolien 2, 20 vernäht wird, wird in der dreieckförmig umgeschlagenen Spezialfolie 2 und 20 jeweils ein Loch 18 (wie es in Fig. 5 zu sehen ist) herausgeschnitten, so dass ein Litzenanteil 11 durch das Loch 18 in der Spezialfolie 2 und der andere Litzenanteil 11 durch das Loch 18 in der Spezialfolie 20 nach innen in den dreieckförmigen Umschlagbereich geführt wird. In dem dreieckförmigen Umschlagbereich sowohl der Spezialfolie 2 als auch der Spezialfolie 20 wird jeder Litzenanteil 11 in der in Fig. 5 gezeigten Weise fächerartig auf der dort befindlichen Metallisierungsschicht 4 beziehungsweise 40 ausgebreitet und auf dieser Schicht beispielsweise durch Tesafilmstreifen 92 befestigt, so dass sich ein guter über eine grosse Fläche hinweg gesicherter Kontakt zwischen Litzenanteil 11 und Metallisierungsschicht 4 beziehungsweise 40 ergibt. Ein weiterer Kontakt ergibt sich zwischen dem jeweiligen Litzenanteil 11 und dem dreieckförmigen umgeschlagenen Teil jeder der Spezialfolien 2, 20. Durch einen weiteren Klebestreifen 12, beispielsweise einen Tesastreifen, wird der umgeschlagene dreieckige Teil der Spezialfolie 2, 20 mit deren Hauptteil in Verbindung gehalten. Die Erdungslitze 10 kann mit ihrem nicht abisolierten noch innerhalb des Bereichs der Schutzdecke 1 verlaufenden Teil ebenfalls in nicht gezeigter Weise mit der Kunststoffschutzfolie 5 verklebt sein. Nachdem dieser Anschluss der Erdungslitze 10 vorgenommen ist, kann darauffolgend auch im Bereich der Ecke 31 der Nähvorgang zum Abschliessen der Schutzdecke 1 durchgeführt werden.

In den Fig. 6 und 7 ist ein Stecker 80 gezeigt mittels welchem die Erdungslitze 10 mit dem in einer Schuckosteckdose vorhandenen Erdpotential in vorteilhafter Weise verbunden werden kann. Dieser Stecker 80 weist die üblichen Erdungskontakte 81 auf, wobei die Litze 10 in zwei Teile 10a und 10b aufgespalten ist, die schleifenförmig bei 10c miteinander und ferner auch bei 82 mit den Erdungskontakten 81 verbunden sind.

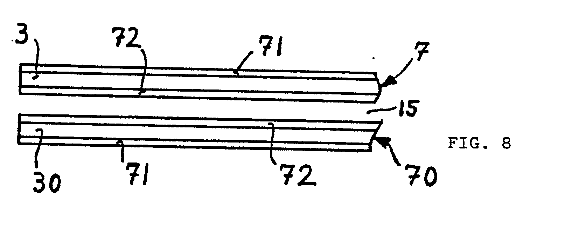

In Fig. 8 ist ein weiteres besonders bevorzugtes Ausführungsbeispiel einer gemäss der Erfindung ausgebildeten Schutzdecke dargestellt. Die in Fig. 2 gezeigten Kunststoffschutzfolien 5 und 6 sind hier nicht, ähnlich wie bei Fig. 3, gezeigt. Die gemäss Fig. 8 ausgebildete erfindungsgemässe Schutzdecke weist zwei Spezialfolien 7, 70 auf. Die Spezialfolie 7 ist identisch mit der Spezialfolie 70 ausgebildet. Die Spezialfolie 7 besitzt eine Kunststoffträgerfolie 3 und die Spezialfolie 70 besitzt eine Kunststoffträgerfolie 30. Auf diese Kunststoffträgerfolien 3, 30 sind jeweils zu beiden Seiten Metallschichten 71, 72 aufgebracht, vorzugsweise aufgedampft. Vorzugsweise sind die bei der Gesamtanordnung gemäss Fig. 8 aussenliegenden Metallschichten 71 als Silberschichten vorgesehen, während die beiden innenliegenden Schichten 72 Goldschichten sind. Bei der fertigen Decke liegen somit die beiden Goldschichten 72, 72 aufeinander, wobei sich eine bestimmte Luftschicht 15 ähnlich wie in Fig. 2 gezeigt, ausbildet.

Die Metallschichten 71, 72 sind jeweils mit der in Fig. 8 nicht dargestellten Erdungslitze 10 verbunden.

## Patentansprüche

1. Schutzdecke mit einem flexiblen, flächenförmigen Aufbau, insbesondere in Grösse eines Bettes, bestehend aus einer Einlage aus einer metallisierten Kunststoff-Folie, die in eine obere und untere Umhüllung eingeschlagen ist, wobei die metallisierte Schicht mit Erde verbindbar ist und die Umhüllungen durchlöcherte Kunststoff-Folien sind, dadurch gekennzeichnet,
– dass die Einlage aus zwei lose aufeinanderliegenden Spezialfolien (2, 20) mit aufgedampften Metallschichten (4, 40) besteht,
– dass die an den Rändern der Decke (1) umgeschlagenen und mit der Einlage vernähten, Umhüllungen (5, 6) gegenüber den Spezialfolien (2,

20) je eine Luftschicht (16, 17) einschliessen, während zwischen den Spezialfolien (2, 20) sich eine Luftschicht (15) bildet,
– dass jede der Metallschichten (4, 40) über Verzweigungen (11) mit einer Erdungslitze (10) verbunden ist, die aus der Decke (1) herausführt und
– dass die Erdungslitze (10) in zwei Verzweigungen (11) aufgespalten ist, deren jede fächerartig (Fig. 5) mit der jeweiligen Metallschicht (4, 40) in Verbindung steht.

2. Schutzdecke nach Anspruch 1, dadurch gekennzeichnet, dass die beiden Spezialfolien (2, 20) mit ihren Kunststoffträgerfolien (3, 30) aufeinander hin weisend angeordnet sind.

3. Schutzdecke nach Anspruch 1, dadurch gekennzeichnet, dass die beiden Spezialfolien (2, 20) mit ihren Metallschichten (4, 40) aufeinander hinweisend angeordnet sind (Fig. 3).

4. Schutzdecke nach Anspruch 1, dadurch gekennzeichnet, dass die beiden Spezialfolien (2, 20) wechselseitig angeordnet sind, das heisst, dass die Metallschicht (4) der einen Spezialfolie (2) benachbart zur Kunststoffträgerfolie (30) der anderen Spezialfolie (20) angeordnet ist (Fig. 4).

5. Schutzdecke nach Anspruch 4, dadurch gekennzeichnet, dass jeweils ein Loch (18) in den Spezialfolien (2, 20) vorgesehen ist, um die Durchführung der Erdungslitze (10) mit ihren Verzweigungen (11) und ein dreieckförmiges Umschlagen der Eckteile der Spezialfolien (2, 20) zu ermöglichen.

6. Schutzdecke nach Anspruch 4 oder 5, dadurch gekennzeichnet, dass die Verbindung der Verzweigungen (11) mit den Metallschichten (4, 40) durch Klebestreifen erfolgt.

7. Schutzdecke nach einem oder mehreren der vorhergehenden Ansprüche, dadurch gekennzeichnet, dass jede der beiden Spezialfolien (7, 70) beidseitig mit einer Metallisierungsschicht (71, 72) versehen ist.

8. Schutzdecke nach Anspruch 7, dadurch gekennzeichnet, dass die beiden Spezialfolien (7, 70) identisch sind.

9. Schutzdecke nach Ansprüchen 1 bis 6, dadurch gekennzeichnet, dass von den beiden vorgesehenen Spezialfolien die eine (beispielsweise 7) beidseitig beschichtet ist, während die andere (beispielsweise 2) nur einseitig beschichtet ist.

10. Schutzdecke nach einem oder mehreren der vorhergehenden Ansprüche, dadurch gekennzeichnet, dass wenigstens eine Spezialfolie (7, 70) auf der einen Seite eine Silberschicht und auf der anderen Seite eine Goldschicht aufweist.

11. Schutzdecke nach einem oder mehreren der vorhergehenden Ansprüche, dadurch gekennzeichnet, dass die Spezialfolien (7, 70) jeweils eine dünne Kunststoffträgerfolie (3, 30) aufweisen, die auf der einen Seite mit Silber und auf der anderen Seite mit Gold beschichtet ist, wobei die Anordnung der beiden Spezialfolien derart vorgesehen ist, dass die beiden Goldschichten (72) benachbart zueinander angeordnet sind, während die beiden Silberschichten (71) jeweils nach aussen weisen.

## Claims

1. A protective cover having a flexible sheet-like design and having in particular the size of a bed, said cover comprising an insert consisting of a metallized plastic foil which is surrounded by an upper and a lower enclosure, said metallized layer being adapted to be connected with ground and said envelopes are pierced plastic foils

characterized in that the insert comprises two special foils (2, 20) upon which metal layers (4, 40) are provided by vapour deposition, said special foils being placed loosely on top of each other,

the enclosures (5, 6) are folded around at the edges of the cover (1) and are stitched together with said insert, said enclosures (5, 6) further defining with respect to said special foils (2, 20) each one layer of air (16, 17), while one layer (16) of air is formed between said special foils (2, 20), each of said metal layers (4, 40) is connected by branches (11) with a grounding cord (10), said grounding cord extends out of said cover, and

the grounding cord (10) is split into two branches (11), each one of which is connected in a fan-like manner (Fig. 5) with the appropriate metal layer (4, 40).

2. The protective cover of claim 1, characterized in that the two special foils (2, 20) are arranged with respect to each other in such a manner that the plastic support foils (3, 30) of said special foils (2, 20) face towards each other.

3. The protective cover of claim 1, characterized in that the two special foils (2, 20) face with their metal layers (4, 40) towards each other, (Fig. 4).

4. The protective cover of claim 1, characterized in that the two special foils (2, 20) are alternately arranged, i.e. the metal layer (4) of one special foil (2) is located adjacent to the plastic support foil (30) of the other special foil (20), (fig. 4).

5. The protective cover of claim 4, characterized in that each one hole (18) is provided in said special foils (2, 20) to allow the extension of said grounding cord (10) with the branches (11) therethrough, to allow further a triangular folding of the corner portions of said special foils (2, 20).

6. The protective cover of claims 4 or 5, characterized in that the connection of said branches (11) with said metal layers (4, 40) is carried out by means of adhesive tapes.

7. The protective cover of one or more of the preceding claims, characterized in that each of said two special foils (7, 70) is provided at both sides with a metallizing layer (71, 72).

8. The protective cover of claim 7, characterized in that the two special foils (7, 70) are identical.

9. The protective cover of claims 1 to 6, characterized in that of the two special foils, the one special foil (e.g. special foil 7) is provided at both sides with a layer, while the other special foil (e.g. special foil 2) is provided on only one side with a special layer.

10. The protective cover of one or more of the preceding claims, characterized in that at least one special foil (7, 70) comprises on one side a silver layer and on the other side a gold layer.

11. The protective cover of one or more of the preceding claims, characterized in that the special foils (7, 70) each comprises a thin plastic support foil (3, 30) which is coated on one side with silver and on the other side with gold, the arrangement of said special foils is provided such that the two gold layers (71) are adjacent to each other, while the two silver layers (72) face towards the outside.

## Revendications

1. Couverture protectrice présentant une structure souple en forme de nappe, en particulier de la taille d'un lit, et se composant d'une garniture constituée par une feuille en matière plastique métallisée, enveloppée dans une enveloppe supérieure et une enveloppe inférieure, la couche métallisée pouvant ainsi être reliée à la terre et les enveloppes étant des feuilles en matière plastique perforées, caractérisée en ce que:

– la garniture se compose de deux feuilles spéciales libres (2, 20) superposées l'une à l'autre et pourvues de couches de métal (4, 40) déposées par métallisation sous vide;

– les enveloppes (5, 6) rabattues au niveau des bords de la couverture (1) et cousues avec la garniture renferment respectivement une couche d'air (16, 17) faisant face aux feuilles spéciales (2, 20), tandis qu'une couche d'air (15) se trouve entre les feuilles spéciales (2, 20);

– chacune des couches de métal (4, 40) est reliée, par l'intermédiaire de branchements, (11) à un cordon de mise à la terre (10) sortant de la couverture (1), et en ce que;

– le cordon de mise à la terre (10) est divisé en deux branchements (11) dont chacun est en liaison, à la manière d'un éventail (fig. 5), avec la couche de métal (4, 40) correspondante.

2. Couverture protectrice selon la revendication 1, caractérisée en ce que les deux feuilles spéciales (2, 20) sont disposées avec leurs feuilles supports en matière plastique (3, 30) tournées l'une vers l'autre.

3. Couverture protectrice selon la revendication 1, caractérisée en ce que les deux feuilles spéciales (2, 20) sont disposées avec leurs couches de métal (4, 40) tournées l'une vers l'autre (fig. 3).

4. Couverture protectrice selon la revendication 1, caractérisée en ce que les deux feuilles spéciales (2, 20) sont disposées en alternance, c'est-à-dire que la couche de métal (4) d'une feuille spéciale (2) est disposée de manière adjacente à la feuille support en matière plastique (30) de l'autre feuille spéciale (20) (fig. 4).

5. Couverture protectrice selon la revendication 4, caractérisée en ce qu'un trou (18) est respectivement prévu dans les feuilles spéciales (2, 20) pour permettre le passage du cordon de mise à la terre (10) pourvu de ses branchements (11) et un rabattement en forme de triangle de la partie formant coin des feuilles spéciales (2, 20).

6. Couverture protectrice selon la revendication 4 ou 5, caractérisée en ce que la liaison des branchements (11) avec les couches de métal (4, 40) s'effectue à l'aide d'un ruban adhésif.

7. Couverture protectrice selon l'une au moins des revendications précédentes, caractérisée en ce que chacune des deux feuilles spéciales (7, 70) est pourvue des deux côtés d'une couche de métallisation (71, 72).

8. Couverture protectrice selon la revendication 7, caractérisée en ce que les deux feuilles spéciales (7, 70) sont identiques.

9. Couverture protectrice selon les revendications 1 à 6, caractérisée en ce que sur les deux feuilles spéciales prévues, l'une (par exemple 7) est revêtue des deux côtés, tandis que l'autre (par exemple 2) n'est revêtue que d'un seul côté.

10. Couverture protectrice selon l'une au moins des revendications précédentes, caractérisée en ce qu'au moins une feuille spéciale (7, 70) présente, d'un côté, une couche d'argent et, de l'autre côté, une couche d'or.

11. Couverture protectrice selon l'une au moins des revendications précédentes, caractérisée en ce que les feuilles spéciales (7, 70) présentent respectivement une feuille support en matière plastique mince (3, 30) revêtue, d'un côté, d'argent et, de l'autre côté, d'or, la disposition des deux feuilles spéciales étant prévue de telle façon que les deux couches d'or (72) sont disposées de manière adjacente l'une de l'autre, tandis que les deux couches d'argent (71) sont respectivement tournées vers l'extérieur.

5

1

31

10

FIG. 1

12    3    9

92

11

18

6

10

FIG. 5

FIG. 2

FIG. 3

FIG. 4

FIG. 6

FIG. 7

FIG. 8